# EUROPÄISCHE PATENTSCHRIFT

(11) **EP 4 070 629 B1**
(45) Veröffentlichungstag und Bekanntmachung des Hinweises auf die Patenterteilung: **15.10.2025**
(21) Anmeldenummer: 20820890.0
(22) Anmeldetag: 07.12.2020
(51) Int. Cl.: H05K 7/20, H05K 7/14

(54) **WECHSELRICHTER MIT KOMPAKTER BAUFORM**
INVERTER OF COMPACT DESIGN
ONDULEUR AYANT UNE CONCEPTION COMPACTE

(30) Priorität: 06.12.2019 DE 102019133377
(43) Veröffentlichungstag der Anmeldung: 12.10.2022
(73) Patentinhaber: SMA Solar Technology AG, 34266 Niestetal (DE)
(72) Erfinder: BRAUN, Gerrit, 34123 Kassel (DE); KNOBLOCH, Andreas, 34121 Kassel (DE); REHBEIN, Matthias, 34134 Kassel (DE); RIGBERS, Klaus, 37079 Goettingen (DE); WAPPLER, Thomas, 34302 Guxhagen (DE)
(86) Internationale Anmeldenummer: PCT/EP2020/084880
(87) Internationale Veröffentlichungsnummer: WO 2021/111004

(56) Entgegenhaltungen:
- EP-A1- 2 849 549
- JP-A- 2002 325 467
- US-A1- 2004 022 041
- US-A1- 2015 208 524
- US-A1- 2018 213 686
- US-A1- 2018 228 048

## Beschreibung

### TECHNISCHES GEBIET DER ERFINDUNG

Die Erfindung betrifft einen Wechselrichter in besonders kompakter Bauform.

### STAND DER TECHNIK

Wechselrichter sind leistungselektronische Geräte, die zur Umwandlung zwischen einem Gleichstrom und einem Wechselstrom eingerichtet sind. Insbesondere sind Wechselrichter bekannt, die elektrische Leistung einer Gleichstromquelle, beispielsweise eines Photovoltaik-Generators, in ein Wechselspannungsnetz einspeisen können, oder elektrische Leistung zwischen einem Gleichstromspeicher, beispielsweise einer Batterie, und einem Wechselspannungsnetz bidirektional austauschen können.

Bekannte Wechselrichter umfassen eine oder mehrere Leiterplatten mit elektrischen und elektronischen Komponenten, insbesondere Leistungshalbleitern in einer Brückenschaltung sowie Kapazitäten und Induktivitäten zur Formung des gewünschten Eingangs- bzw. Ausgangsstroms des Wechselrichters. Die elektrischen und elektronischen Komponenten können ganz unterschiedlich im Wechselrichter angeordnet sein, wobei eine Montage der Komponenten auf Leiterplatten üblich ist. Dazu können die Komponenten als sogenannte SMD-Bauteile (Surface-mounted Device) und/oder als THT-Bauteile (Through-hole Technology) ausgeführt sein, wobei diese Bauteile signifikant unterschiedliche Eigenschaften und Baugrößen aufweisen können.

Zur Kühlung bzw. Entwärmung der verlustbehafteten elektrischen und elektronischen Komponenten eines Wechselrichters ist es bekannt, einen oder mehrere Kühlkörper im oder am Wechselrichter anzuordnen. Die zu entwärmenden Komponenten stehen dabei in direkten oder mittelbaren thermischen Kontakt mit einem solchen Kühlkörper des Wechselrichters.

Aus der DE 10 2009 058 270 A1 ist ein Wechselrichter mit einem Gehäuse, einem Wasserkühler, einem Leistungsmodul, einem Kondensator, sowie einer Baugruppe im Sandwich-Aufbau bekannt, wobei die Baugruppe zwei Leiterplatten und eine Kühlplatte umfasst und der Kondensator und das Leistungsmodul zwischen der Baugruppe und dem Wasserkühler angeordnet sind.

Aus der DE 10 2017 127 895 A1 ist ein Wechselrichter bekannt, bei dem Komponenten eines Leistungsteils des Wechselrichters auf einer Seite einer ersten Leiterplatte angeordnet sind, wobei die andere Seite der ersten Leiterplatte mittels eines Niederhalters flächig auf einer Gehäusewand fixiert wird, die als Teil einer Kühlvorrichtung ausgebildet ist, und wobei auf dem Niederhalter eine zweite Leiterplatte mit einer Ansteuereinheit des Wechselrichters angeordnet sein kann.

Aus der US 2018 / 0 228 048 A1 ist ein Wechselrichter für ein Kraftfahrzeug bekannt, bei dem eine Grundplatte auf einem Kühlkörper montiert ist, wobei Komponenten des Wechselrichters, insbesondere eine Kapazität, auf der Grundplatte und ein EMV-Filter auf einer zweiten Ebene montiert angeordnet sind, wobei die zweite Ebene auf einer dem Kühlkörper gegenüberliegenden Seite der Grundplatte angeordnet ist und durch eine Oberfläche eines Gehäuses um eine Kapazität des Wechselrichters gebildet wird.

Aus der EP 2 849 549 A1 ist eine Anordnung elektrischer Bauteile auf einer Leiterplatte bekannt, wobei die Bauteile als SMD-Bauteile auf der Bauteilseite der Leiterplatte oder als THT-Bauteile auf der dem Bauteil gegenüberliegenden Seite der Leiterplatte mit den Leiterbahnen der Leiterplatte verbunden sind.

Aus der JP 2002 - 325 467 A ist ein Wechselrichter mit einem Kühlkörper und einer parallel zur Oberfläche des Kühlkörpers ausgerichteten Leiterplatte bekannt, bei dem Leistungshalbleiter des Wechselrichters zwischen dem Kühlkörper und der Leiterplatte angeordnet und durch Montage direkt auf dem Kühlkörper in thermischen Kontakt mit dem Kühlkörper sind.

Aus der US 2018 / 0 213 686 A1 ist ein Wechselrichter mit zwei im Wesentlichen parallel zueinander orientierten Montageebenen für Bauteile des Wechselrichters bekannt, wobei mittels eines Lüfters ein Kühlluftstrom zwischen den Montageebenen erzeugt wird.

Aus der US 2004 / 0 022 041 A1 ist Leistungswandler mit zwei im Wesentlichen parallel zueinander orientierten Leiterplatten bekannt, bei dem Komponenten des Wechselrichters auf den beiden Leiterplatten mittels eines SMD-Verfahrens befestigt sind.

Aus der US 2015 / 208 524 A1 ist eine Halbleiter-Vorrichtung mit zwei im Wesentlichen parallel zueinander orientierten Leiterplatten und einem Gehäuse bekannt, wobei Anschlussterminals auf der oberen Leiterplatte der beiden Leiterplatten angeordnet sind und externe Anschlüsse der Anschlussterminals durch Löcher in dem Gehäuse nach außen geführt sind.

### AUFGABE DER ERFINDUNG

Der Erfindung liegt die Aufgabe zugrunde, einen Wechselrichter bereitzustellen, der im Vergleich zu bekannten Wechselrichtern eine höhere Leistungsdichte aufweist, sowie kompakter und kostengünstiger aufgebaut ist.

### LÖSUNG

Die Aufgabe wird durch einen Wechselrichter mit den Merkmalen des Patentanspruchs 1 gelöst. Bevorzugte Ausführungsformen sind in den abhängigen Patentansprüchen definiert.

### BESCHREIBUNG DER ERFINDUNG

Ein Wechselrichter mit mehr als 3 kVA Nennleistung weist eine erste Baugruppe und eine zweite Baugruppe auf. Die erste Baugruppe umfasst eine erste Leiterplatte und eine DC/AC-Konverterstufe. Die zweite Baugruppe umfasst eine zweite Leiterplatte und einen EMV-Filter für die DC/AC-Konverterstufe. Die erste Leiterplatte ist auf einem Kühlkörper montiert und liegt im Wesentlichen flächig auf dem Kühlkörper auf.

Die DC/AC-Konverterstufe weist Wandlerkomponenten auf, die Leistungshalbleiter, Drosseln und Zwischenkreiskondensatoren umfassen. Die Drossel und die Zwischenkreiskondensatoren sind gemeinsam auf einer Seite der ersten Leiterplatte angeordnet, und der Kühlkörper ist auf der gegenüberliegenden Seite der ersten Leiterplatte angeordnet. Die Drosseln und/oder die Leistungshalbleiter sind über die erste Leiterplatte und ein zwischen der ersten Leiterplatte und dem Kühlkörper angeordnetes Wärmeleitmaterial thermisch mit dem Kühlkörper verbunden, so dass ihre im Betrieb des Wechselrichters entstehende Verlustwärme im Wesentlichen über den Kühlkörper abgeführt wird.

Die zweite Leiterplatte ist auf der dem Kühlkörper gegenüberliegenden Seite der ersten Leiterplatte angeordnet. Die zweite Leiterplatte ist auf einem Blech montiert, das zwischen der ersten und der zweiten Baugruppe angeordnet ist.

Die Aufteilung der Komponenten des Wechselrichters auf zwei Baugruppen ermöglicht einen kompakten Aufbau. Insbesondere die Anordnung der ersten Leiterplatte mit den Wandlerkomponenten der DC/AC-Konverterstufe auf dem Kühlkörper gewährleistet eine gute Entwärmung der Komponenten, die für den Großteil der im Betrieb des Wechselrichters entstehenden Verlustwärme verantwortlich sind. In Verbindung mit der Entwärmung der zweiten Leiterplatte und der darauf angeordneten Komponenten durch das Blech zwischen den Baugruppen kann eine besonders hohe Leistungsdichte erzielt werden. Darüber hinaus hat das Blech sowohl eine mechanisch stabilisierende als auch eine abschirmende Funktion, indem es ein Übersprechen zwischen den Baugruppen verhindert, die Wandlerkomponenten vor äußeren elektromagnetischen Feldern abschirmt und die Umgebung vor elektromagnetische Emissionen der Wandlerkomponenten schützt.

Die Erfindung basiert auf der Erkenntnis, dass für einen Wechselrichter aufgrund technischer Fortschritte sehr effiziente Topologien zur Verfügung stehen, die sich unter anderem dadurch auszeichnen, dass ihre Wandlerkomponenten wie Zwischenkreiskapazitäten und Drosseln für einen stabilen Betrieb vergleichsweise klein ausgelegt werden können. Insbesondere dreiphasige Topologien, beispielsweise sogenannte B6-Brückenschaltungen, sowie sogenannte FlyingCap-Topologien, die sowohl einphasig als auch dreiphasig ausgeführt sein können, kommen dafür in Betracht.

Daher können die Zwischenkreiskapazitäten und die Drosseln sowie etwaige weitere Wandlerkomponenten wie Filterkondensatoren und/oder Stromsensoren, die auf der ersten Leiterplatte angeordnet sind, selbst für Nennleistungen von mehr als 3 kVA sämtlich als SMD-Komponenten ausgeführt sein. Alternativ oder zusätzlich können einzelne Wandlerkomponenten auch als leiterplatten-integrierte Strukturen ausgeführt sein, beispielsweise als Planarspulen, die aus den Leiterbahnen der Leiterplatte selbst gebildet werden kann.

In einer alternativen Ausführungsform können die Leistungshalbleiter sowie die Drosseln als SMD-Komponenten ausgeführt sein, während die Zwischenkreiskondensatoren als **THT-**Komponenten ausgeführt sind. Damit sind bei Bedarf größere Zwischenkreiskapazitäten realisierbar. Allerdings weisen die THT-Komponenten Anschlussdrähte auf, die sich durch die sie tragende Leiterplatte hindurch erstrecken und auf der den THT-Komponenten gegenüberliegenden Seite elektrisch kontaktiert werden, z.B. durch Löten. Somit erstrecken sich die Anschlussdrähte der THT-Komponenten, die auf der ersten Leiterplatte angeordnet sind, in einen Raum zwischen der ersten Leiterplatte und dem Kühlkörper.

Der Kühlkörper weist bevorzugt eine im Wesentlichen ebene Kühlfläche auf, die beispielsweise die Bodenplatte eines Aluminium-Strangpress-Kühlkörpers umfasst. Da die erste Leiterplatte im Wesentlichen flächig auf dem Kühlkörper aufliegt, erweist es sich als für die flächige thermische Anbindung der ersten Leiterplatte mit THT-Komponenten als vorteilhaft, wenn die der ersten Leiterplatte zugewandte Kühlfläche des Kühlköpers an den Positionen der Anschlussdrähte Aussparungen aufweist, insbesondere in Form von Vertiefungen. Die Aussparungen gewährleisten einen hinreichend großen Abstand zwischen den Anschlussdrähten der THT-Komponenten und dem Kühlkörper und damit eine elektrische Isolation derselben gegeneinander.

Der Kühlkörper kann ein Strangpressprofil mit in Pressrichtung angeordneten Kühlrippen umfassen. Dabei erweist es sich als vorteilhaft, eine Aussparung als grabenförmige Vertiefung in der im Wesentlichen ebenen Kühlfläche des Strangpressprofils auszuführen, so dass die Anschlussdrähte in die grabenförmige Vertiefung hineinragen. Die grabenförmige Vertiefung kann bevorzugt parallel zu den Kühlrippen des Kühlkörpers verlaufen und so besonderes einfach bereits bei der Herstellung eines Strangpressprofils vorgesehen sein. um eine kostengünstige Herstellung des Kühlkörpers zu erreichen.

Alternativ oder zusätzlich können die Aussparungen einzeln an den jeweiligen Positionen der THT-Komponenten bzw. den Positionen der einzelnen Anschlussdrähte der THT-Komponenten angeordnet sein, beispielsweise als flache Ausfräsungen auf der Kühlfläche. Dabei kann der jeweilige Durchmesser der Aussparungen so ausgelegt sein, dass genau ein Anschlussdraht eines THT-Bauteils in jeweils einer Vertiefung angeordnet ist. Bei einer überschaubaren Anzahl an auf der ersten Leiterplatte angeordneten THT-Bauteilen, beispielsweise etwa ein Dutzend, können allen Anschlussdrähten aller THT-Bauteile auf der ersten Leiterplatte jeweils individuelle Aussparungen zugeordnet sein, beispielsweise indem die Oberfläche des Kühlkörper an den Positionen der Anschlussdrähte punktuell ausgefräst wird. Insgesamt wird dadurch die Kühlfläche des Kühlkörpers optimal zur Entwärmung insbesondere der ersten Baugruppe genutzt.

Alternativ oder zusätzlich kann der Durchmesser derartiger Aussparungen so ausgelegt sein, dass alle Anschlussdrähte genau eines THT-Bauteils in jeweils einer gemeinsamen Aussparung angeordnet sind. Solche gemeinsamen Aussparungen weisen einen größeren Durchmesser als die den Anschlussdrähten individuell zugeordneten Aussparungen auf, nehmen jedoch in Summe nur einen Bruchteil der Gesamtoberfläche des Kühlkörpers in Anspruch, so dass der weit überwiegende Teil der Oberfläche des Kühlkörpers thermisch optimal mit der ersten Leiterplatte verbunden werden kann.

Es versteht sich, dass dabei ein vorgegebener Isolationsabstand zwischen Anschlussdraht und Kühlkörper ggf. zusätzlich einzuhalten ist. Darüber hinaus können die Aussparungen mit einem dünnen elektrisch isolierenden Material ausgekleidet sein, um die Isolation zwischen den Anschlussdrähten und dem Kühlkörper sicherzustellen.

In einer Ausführungsform eines erfindungsgemäßen Wechselrichters beträgt der Abstand zwischen den Leiterplatten weniger als fünf Zentimeter und bevorzugt weniger als drei Zentimeter. Dadurch wird eine besonders kompakte Bauform ermöglicht, die sich an der Bauhöhe der SMD-Komponenten orientiert und insbesondere die Vorteile der Bestückung der ersten Leiterplatte mit SMD-Bauteilen voll ausschöpft.

In einer weiteren Ausführungsform eines erfindungsgemäßen Wechselrichters beträgt der Abstand zwischen der ersten Leiterplatte und der Kühlfläche des Kühlkörpers im Mittel weniger als ein Zentimeter und bevorzugt weniger als fünf Millimeter. Unter Berücksichtigung des Wärmeleitmaterials, das etwaige baulich bedingte Mindestabstände überbrückt, steht die Lieterplatte damit in direktem thermischen Kontakt zum Kühlkörper. Dadurch wird eine ideale thermische Anbindung der Leiterplatte und damit der ersten Baugruppe an die Kühlfläche und damit an den Kühlkörper gewährleistet.

Die Leistungshalbleiter der ersten Baugruppe können auf der dem Kühlkörper zugewandten Seite der ersten Leiterplatte angeordnet sein, um eine unmittelbare thermische Verbindung zwischen Leistungshalbleiter und Kühlkörper zu ermöglichen. Dabei erweist es sich als vorteilhaft, an den Positionen der Leistungshalbleiter Aussparungen in der Kühlfläche des Kühlkörpers vorzusehen, so dass die Leiterplatte und die Leistungshalbleiter im Wesentlichen denselben Abstand zur Kühlfläche aufweisen, d.h. z.B. mit dem gleichen Wärmeleitmaterial thermisch an den Kühlkörper angekoppelt sind. Die Tiefe der Aussparungen gegenüber der Kühlfläche ist dann insbesondere gleich der Bauhöhe der Leistungshalbleiter.

In einer Ausführungsform weist die zweite Baugruppe des Wechselrichters Filterkomponenten auf, die auf einer der ersten Leiterplatte gegenüberliegenden Seite der zweiten Leiterplatte angeordnet sind.

In einer Ausführungsform eines erfindungsgemäßen Wechselrichters weist die erste Baugruppe mindestens zwei Drosseln auf, die über ein zwischen den Drosseln und dem Blech angeordnetes Wärmeleitmaterial thermisch mit dem Blech verbunden sind. Alternativ oder zusätzlich kann mindestens einer der Zwischenkreiskondensatoren der ersten Baugruppe über ein zwischen dem Zwischenkreiskondensator und dem Blech angeordnetes Wärmeleitmaterial thermisch mit dem Blech verbunden sein. In Kombination mit der thermischen Verbindung der Drosseln und/oder der Zwischenkreiskondensatoren mit dem Kühlkörper wird die Entwärmung der Wandlerkomponenten über das Blech weiter verbessert.

Darüber hinaus kann der Wechselrichter einen Lüfter aufweisen, der eine Luftströmung entlang des Blechs zwischen der ersten und der zweiten Baugruppe erzeugt und so weiter zur optimalen Abführung der Verlustwärme des Wechselrichters beiträgt.

Das Blech zwischen den Baugruppen ist im Wesentlichen parallel zu den Leiterplatten orientiert und kann darüber hinaus Abschnitte aufweisen, die sich aus der Ebene des Blechs heraus und in den Bauraum der ersten Baugruppe hinein erstrecken. Diese Abschnitte tragen sowohl zur Stabilisierung des Blechs als auch zur Erhöhung der Kühlleistung des Blechs bei, insbesondere wenn die Abschnitte von der Luftströmung des Lüfters erfasst werden, und können die Luftströmung zudem gezielt lenken.

In einer weiteren Ausführungsform eines erfindungsgemäßen Wechselrichters umfasst die erste Baugruppe eine DC/DC-Konverterstufe, wobei die DC/DC-Konverterstufe über die Zwischenkreiskondensatoren mit einer DC/AC-Konverterstufe verbunden ist. Dadurch kann insbesondere ein nutzbarer Bereich für eine Eingangsspannung des Wechselrichters erweitert werden. Die Leistungshalbleiter der DC/DC-Konverterstufe können als Siliziumkarbid- oder Galliumnitrid-Halbleiter ausgeführt sein. Darüber hinaus können die Leistungshalbleiter der DC/AC-Konverterstufe als Siliziumkarbid- oder Galliumnitrid-Halbleiter ausgeführt sein.

Die erste Baugruppe eines erfindungsgemäßen Wechselrichters kann eine Steuereinheit umfassen, die auf der ersten Leiterplatte angeordnet und dazu eingerichtet ist, die Leistungshalbleiter mittels eines pulsweitenmodulierten Taktsignals anzusteuern sowie Strom- und Spannungsmesswerte der DC/AC-Konverterstufe zu erfassen. Die Steuereinheit kann insbesondere dazu eingerichtet sein, die Leistungshalbleiter mit einer Schaltfrequenz von mindestens 100 kHz zu schalten. Darüber hinaus kann die DC/AC-Konverterstufe des Wechselrichters mindestens zwei Halbbrücken umfassen, wobei die Steuereinheit dazu eingerichtet ist, die Leistungshalbleiter der zwei Halbbrücken periodisch mit einem Phasenversatz von mindestens 90 Grad bezogen auf die Schaltperiode zu schalten.

Die Verwendung von Siliziumkarbid- oder Galliumnitrid- Leistungshalbleitern in Verbindung mit einer hohen Schaltfrequenz und ggf. einer phasenversetzten Verschachtelung der Taktung mehrerer parallel geschalteter Halbbrücken einer DC/AC-Konverterstufe ermöglichen es, bereits am Ausgang der Halbbrücken, also vor einer Glättung durch die Drossel, verzerrungsarme Stromverläufe zu erzeugen. Dadurch können sowohl die Drossel als auch die Zwischenkreiskondensatoren nochmals kleiner ausgelegt werden, bzw. höhere Nennleistungen bei gleicher Auslegung erzielt werden.

Ein erfindungsgemäßer Wechselrichter kann dazu eingerichtet sein, eine elektrische Leistung mindestens einer anschließbaren Gleichspannungseinheit über die DC/AC-Konverterstufe und den EMV-Filter mit einer Phasenleitung eines Niederspannungsnetzes auszutauschen. Insbesondere kann der Wechselrichter elektrische Leistung normkonform in ein Niederspannungsnetz einspeisen und/oder aus einem Niederspannungsnetz entnehmen. In einer Ausführungsform ist der Wechselrichter dreiphasig ausgeführt und dazu eingerichtet, elektrische Leistung auf allen drei Phasen mit einem dreiphasigen Niederspannungsnetz auszutauschen. Die Gleichspannungseinheit am DC-Eingang des Wechselrichters kann insbesondere einen Photovoltaik-Generator und/oder eine Batterie umfassen.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt einen Wechselrichter in einer ersten Ausführungsform,
- Fig. 2: zeigt einen Wechselrichter in einer zweiten Ausführungsform,
- Fig. 3: zeigt einen Wechselrichter in einer dritten Ausführungsform, und
- Fig. 4: zeigt eine Ausführungsform eines Kühlkörpers für einen Wechselrichter.
- Fig. 5: zeigt einen Wechselrichter in einer vierten Ausführungsform.

### FIGUREN BESCHREIBUNG

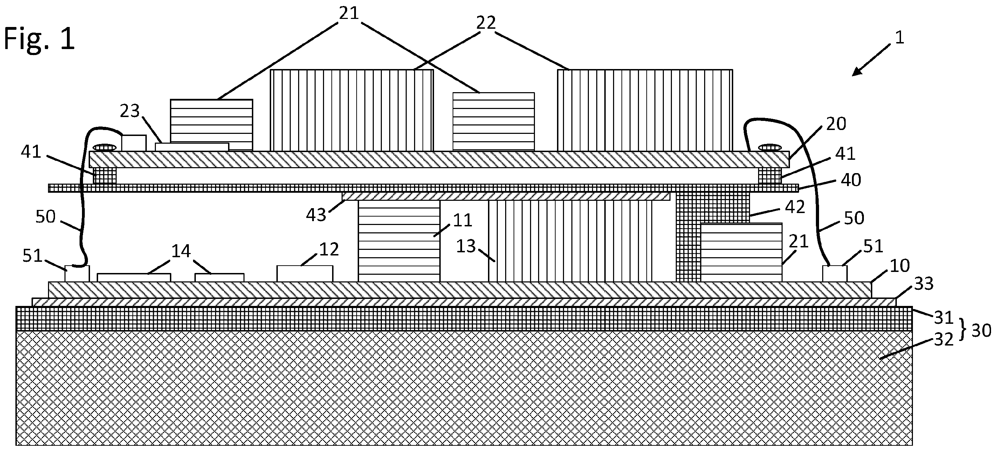

**Fig. 1** zeigt einen Wechselrichter 1 in einer vereinfachten Querschnittsdarstellung. Dargestellt sind die leistungselektronischen Komponenten des Wechselrichters 1. Es versteht sich, dass für einen tatsächlichen Betrieb des Wechselrichters, beispielsweise als Batterie- oder Photovoltaik-Wechselrichter zur Versorgung einer Last oder zur Einspeisung in ein Wechselspannungsnetz, weitere elektrische, elektromechanische und mechanische Komponenten notwendig sind, die in Fig. 1 der Übersichtlichkeit halber nicht dargestellt sind. Dazu gehören insbesondere DC- und AC-Anschlussvorrichtungen, Relais, ein Gehäuse und ähnliches.

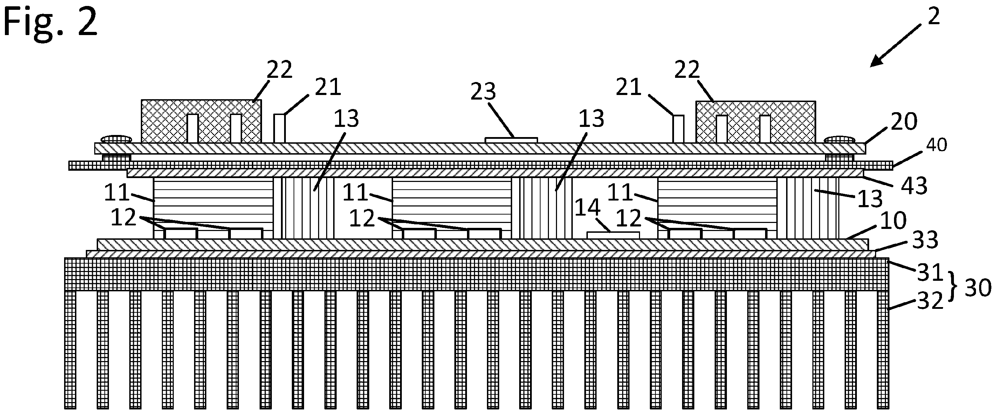

Der Wechselrichter 1 umfasst eine erste Leiterplatte 10 und eine zweite Leiterplatte 20. Die erste Leiterplatte 10 ist auf einem Kühlkörper 30 montiert. Der Kühlkörper 30 umfasst eine im wesentlichen ebene Kühlfläche 31 und daran angeordnete Kühlrippen 32, wobei die Kühlrippen 32 derart zueinander beabstandet sind, dass Kühlluft zwischen den Kühlrippen 32 durchströmen kann (vergleiche Fig. 2). Zwischen der ersten Leiterplatte 10 und der Kühlfläche 31 ist ein Wärmeleitmaterial 33 angeordnet. Das Wärmeleitmaterial 33 kann insbesondere einstückig ausgebildet sein und die gesamte Auflagefläche der ersten Leiterplatte 10 auf dem Kühlkörper 30 bedecken. Alternativ kann das Wärmeleitmaterial 33 aus mehreren Stücken und/oder einer viskosen Masse bestehen, wobei lediglich ein Teil der besagten Auflagefläche bedeckt sein kann.

Auf der ersten Leiterplatte 10 sind verschiedene leistungselektronische Wandlerkomponenten angeordnet, die im Zusammenwirken insbesondere eine DC/AC-Konverterstufe bilden. Die DC/AC-Konverterstufe umfasst dabei insbesondere einen Zwischenkreiskondensator 11, Leistungshalbleiter 12 und eine Drossel 13 sowie ggf. weitere Peripherie-Komponenten wie insbesondere eine Steuereinheit 14 sowie weitere Treiber, Controller und/oder andere elektronische Kleinteile (Widerstände, ICs und ähnliches).

Die Komponenten auf der ersten Leiterplatte 10 können insbesondere als oberflächenmontierte Bauteile ausgeführt sein, also als sogenannte Surface-mounted devices (kurz: SMD-Bauteile). SMD-Bauteile zeichnen sich insbesondere dadurch aus, dass sie auf der Seite der Leiterplatte, auf der die Bauteile angeordnet sind, auch elektrisch mit den Leiterbahnen der Leiterplatte kontaktiert werden, so dass für die Montage von SMD-Bauteilen kein Zugriff auf die den Bauteilen abgewandte Seite der Leiterplatte erfolgen muss. Im Gegensatz dazu werden sogenannte THT-Komponenten, die zur Durchsteckmontage vorgesehen sind (THT = Through-hole technology), auf der den THT-Komponenten abgewandten Seite der Leiterplatte elektrisch mit den Leiterbahnen der Leiterplatte kontaktiert, insbesondere gelötet.

Sofern auf der ersten Leiterplatte 10 entsprechend Fig. 1 keine THT-Komponenten angeordnet sind, kann die Leiterplatte 10 vollflächig über das Wärmeleitmaterial 33 thermisch mit der Kühlfläche 31 verbunden werden. Das Wärmeleitmaterial 33 wird dabei in der Regel so dünn wie möglich ausgeführt, so dass sichergestellt ist, dass der thermische Widerstand zwischen der ersten Leiterplatte 10 und dem Kühlkörper 30 möglichst gering ist. Der thermische Widerstand wird dabei möglichst ausschließlich durch das Wärmeleitmaterial 33 gebildet und nicht etwa durch Luft mit einem deutlich höheren thermischen Widerstand. Dadurch wird eine in den Wandlerkomponenten 11-13 entstehende Verlustwärme im Betrieb des Wechselrichters 1 durch die erste Leiterplatte 10 und über das Wärmeleitmaterial 33 in den Kühlkörper 30 und von dort an die Umgebung effektiv abgeführt.

Auf der zweiten Leiterplatte 20 sind verschiedene weitere Komponenten des Wechselrichters 1 angeordnet, die insbesondere einen EMV-Filter für die DC/AC-Konverterstufe auf der ersten Leiterplatte 20 bilden. Der EMV-Filter umfasst insbesondere Filterkondensatoren 21 und Filterdrosseln 22, wobei ein weiterer Filterkondensator 21 auf der ersten Leiterplatte 10 angeordnet sein kann. Zusätzlich ist auf der zweiten Leiterplatte beispielsweise ein Kommunikationsprozessor 23 angeordnet. Elektrische Verbindungen 50, beispielsweise Kabel oder Stromschienen, die an Verbindungselemente 51, beispielsweise Buchsen oder Schraubklemmen angeschlossen sind, verbinden die DC/AC-Konverterstufe auf der ersten Leiterplatte 10 mit dem EMV-Filter auf der zweiten Leiterplatte 20. Dabei sind die Verbindungen 50 so ausgelegt, dass sie insgesamt eine elektrische Leistung übertragen können, die mindestens der Nennleistung des Wechselrichter 1 entspricht. Zusätzlich können geeignete Signalleitungen zur Übertragung von internen Steuerungs- und Betriebssignalen zwischen den Leiterplatten 10 und 20 angeordnet sein.

Die zweite Leiterplatte 20 ist mittels der Befestigungsmittel 41 auf einem Blech 40 montiert, beispielsweise geschraubt oder geclipst. Das Blech 40 liegt auf dem Zwischenkreiskondensator 11 und der Drossel 13 auf, wobei zwischen dem Blech 40 und dem Zwischenkreiskondensator 11 bzw. der Drossel 13 ein Wärmeleitmaterial 43 angeordnet ist. Dadurch ist insbesondere die Position des Blechs 40 und damit auch der zweiten Leiterplatte 20 festgelegt. Zusätzlich kann ein weiteres Halteblech 42 vorgesehen sein, das das Blech 40 mechanisch direkt mit der ersten Leiterplatte 10 verbindet. Im Betrieb des Wechselrichters 1 wird im Zwischenkreiskondensator 11 und in der Drossel 13 entstehende Verlustwärme über das Wärmeleitmaterial 43 in das Blech 40 und von dort an die Umgebung effektiv abgeführt.

**Fig. 2** zeigt einen weiteren Wechselrichter 2 in einer vereinfachten Querschnittsdarstellung. Grundsätzlich gleiche Teile, die bereits in Zusammenhang mit Fig. 1 beschrieben wurden, sind mit den gleichen Bezugszeichen versehen.

Auf der ersten Leiterplatte 10 sind mehrere Zwischenkreiskondensatoren 11, Leistungshalbleiter 12 und Drosseln 13 als Komponenten einer DC/AC-Konverterstufe angeordnet. Die DC/AC-Konverterstufe und damit der Wechselrichter 2 insgesamt können insbesondere dreiphasig ausgeführt sein, wobei die Komponenten 12, 13 ebenfalls jeweils dreifach ausgeführt sind, wobei ein Paar an Leistungshalbleitern 12 eine Halbbrücke einer Phase des dreiphasigen Wechselrichter 2 bilden kann.

Die erste Leiterplatte 10 ist vollflächig über das Wärmeleitmaterial 33 thermisch mit der Kühlfläche 31 verbunden, sofern die Komponenten der DC/AC-Konverterstufe weitgehend als SMD-Komponenten ausgebildet sind und insbesondere keine THT-Komponenten auf der ersten Leiterplatte 10 angeordnet sind. Dadurch wird eine effektive Abfuhr der in den Komponenten 11, 12, 13 auf der ersten Leiterplatte 10 entstehenden Verlustwärme in den Kühlkörper 30 und von dort an die Umgebung gewährleistet.

Auf der zweiten Leiterplatte 20 sind weitere Komponenten des Wechselrichters 2 angeordnet, insbesondere EMV-Filter umfassend Filterkondensatoren 21 und Filterdrosseln 22 sowie der Kommunikationsprozessor 23. Elektrische Verbindungen zwischen den Leiterplatten 10 und 20 sind selbstverständlich vorgesehen, vergleiche Fig. 1, in Fig. 2 jedoch der Übersichtlichkeit halber nicht dargestellt.

Zwischen der ersten Leiterplatte 10 und der zweiten Leiterplatte 20 ist das Blech 40 angeordnet. Die zweite Leiterplatte 20 ist auf dem Blech 40 befestigt. Das Blech 40 liegt auf den Zwischenkreiskondensatoren 11 und den Drosseln 13 auf, so dass die Position des Blechs 40 und damit auch der zweiten Leiterplatte 20 festgelegt ist. Zwischen dem Blech 40 und den Zwischenkreiskondensatoren 11 bzw. den Drosseln 13 ist das Wärmeleitmaterial 43 angeordnet. Dadurch wird ein Teil der Verlustwärme der Zwischenkreiskondensatoren 11 und der Drosseln 13 im Betrieb des Wechselrichters 2 über das Wärmeleitmaterial 43 in das Blech 40 eingeleitet und von dort an die Umgebung abgeführt.

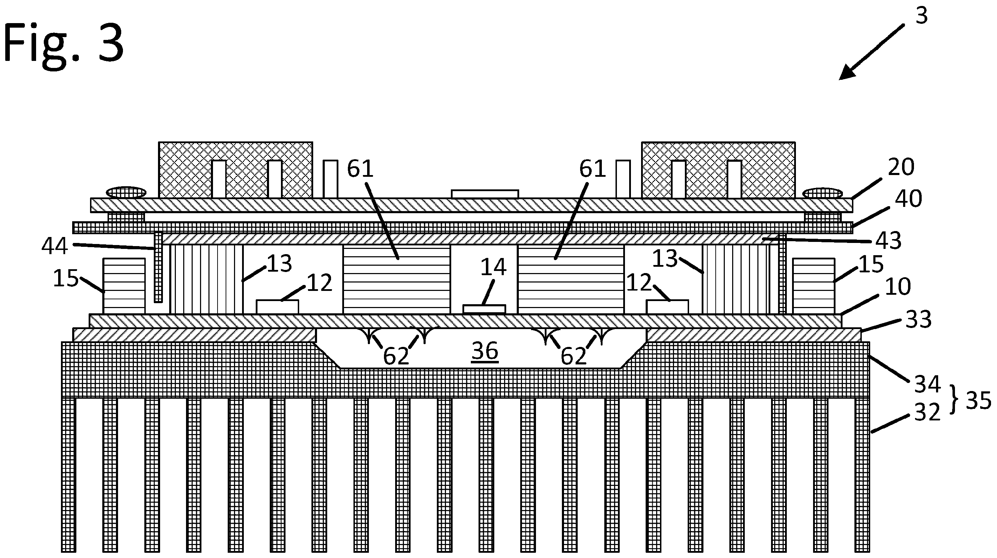

**Fig. 3** zeigt einen weiteren Wechselrichter 3 in einer vereinfachten Querschnittsdarstellung. Grundsätzlich gleiche Teile, die bereits in Zusammenhang mit Fig. 1 oder Fig. 2 beschrieben wurden, sind mit den gleichen Bezugszeichen versehen. Der Wechselrichter 3 umfasst die erste Leiterplatte 10 und die zweite Leiterplatte 20. Die erste Leiterplatte 10 ist auf dem Kühlkörper 35 montiert.

Der Kühlkörper 35 des Wechselrichters 3 weist eine Kühlfläche 34 auf, die im wesentlichen ebene Flächenabschnitte umfasst, wobei sich ein Großteil der Kühlfläche 34 in einer ersten Ebene befindet. Mindestens einer der Flächenabschnitte der Kühlfläche 34 liegt jedoch in einer zweiten Ebene, so dass der Kühlkörper 35 einen Graben 36 aufweist. Der Kühlkörper 34 umfasst Kühlrippen 32, über die Verlustwärme des Wechselrichters 3 an die Umgebung abgegeben wird.

Auf der ersten Leiterplatte 10 ist eine DC/AC-Konverterstufe angeordnet, die insbesondere Zwischenkreiskondensatoren 61, Leistungshalbleiter 12 und Drosseln 13 umfasst. Im Gegensatz zu den Wechselrichtern 1 und 2 gemäß Fig. 1 bzw. 2 sind auf der ersten Leiterplatte 10 nun auch THT-Komponenten angeordnet, hier insbesondere die Zwischenkreiskondensatoren 61. Die Zwischenkreiskondensatoren 61 weisen Anschlussdrähte 62 auf, die sich durch die Leiterplatte 10 erstrecken und auf der den Bauteilen gegenüberliegenden Seite der Leiterplatte 10 befestigt sind, insbesondere mittels einer Lötverbindung. Zusätzlich können eine Steuereinheit 14 und ggf. weitere Kapazitäten 15 auf der ersten Leiterplatte 10 angeordnet sein, die bevorzugt als SMD-Bauteile ausgeführt sind.

Die erste Leiterplatte 10 weist somit einerseits Bereiche auf, in denen THT-Komponenten angeordnet sind. Die Anschlussdrähte 62 der als THT-Komponenten ausgeführten Zwischenkreiskondensatoren 61 erstrecken sich durch die erste Leiterplatte 10 hindurch. Die erste Leiterplatte 10 kann im Bereich der THT-Komponenten aufgrund der Anschlussdrähte 62 nicht ohne Weiteres voll auf der Kühlfläche 34 aufliegen. Die THT-Komponenten erfordern vielmehr einen Abstand zwischen erster Leiterplatte 10 und Kühlfläche 34, in Fig. 3 realisiert durch den Graben 36. Die Tiefe des Grabens 36 ist so ausgelegt, dass eine elektrische Isolation zwischen den Anschlussdrähten 62 und dem Kühlkörper 35 gesichert ist.

Andererseits weist die erste Leiterplatte 10 weite Bereiche auf, in denen keine THT-Komponenten angeordnet sind. In diesen Bereichen der Leiterplatte 10 sind insbesondere Komponenten angeordnet, die. Diese Bereiche ohne THT-Komponenten sind flächig über das Wärmeleitmaterial 33 thermisch mit der Kühlfläche 34 verbunden. Insbesondere die Komponenten, die vergleichsweise viel Verlustwärme erzeugen, sind in diesen Bereichen angeordnet, so dass die Verlustwärme der Leistungshalbleiter 12, der Drosseln 13 sowie ggf. der Kapazitäten 15 effektiv durch die erste Leiterplatte 10 und über das Wärmeleitmaterial 33 in den Kühlkörper 35 und von dort an die Umgebung abgeführt wird.

Zwischen der ersten Leiterplatte 10 und der zweiten Leiterplatte 20 ist das Blech 40 angeordnet. Die zweite Leiterplatte 20 ist auf dem Blech 40 befestigt. Das Blech 40 liegt auf den Zwischenkreiskondensatoren 61 und den Drosseln 13 auf, so dass die Position des Blechs 40 und damit auch der zweiten Leiterplatte 20 festgelegt ist.

Zwischen dem Blech 40 und den Zwischenkreiskondensatoren 61 bzw. den Drosseln 13 ist das Wärmeleitmaterial 43 angeordnet. Dadurch wird die Verlustwärme der Zwischenkreiskondensatoren 61 und der Drosseln 13 im Betrieb des Wechselrichters 2 über das Wärmeleitmaterial 43 in das Blech 40 eingeleitet und von dort an die Umgebung abgeführt. Zusätzlich kann ein Führungsblech 44 vorgesehen sein, das eine beispielsweise von einem Lüfter erzwungene Luftströmung durch den Zwischenraum zwischen erster Leiterplatte 10 und Blech 40 führt. Darüber hinaus kann das Blech 40 über ein Halteblech 42 mechanisch direkt mit der ersten Leiterplatte 10 verbunden werden (vergl. Fig. 1).

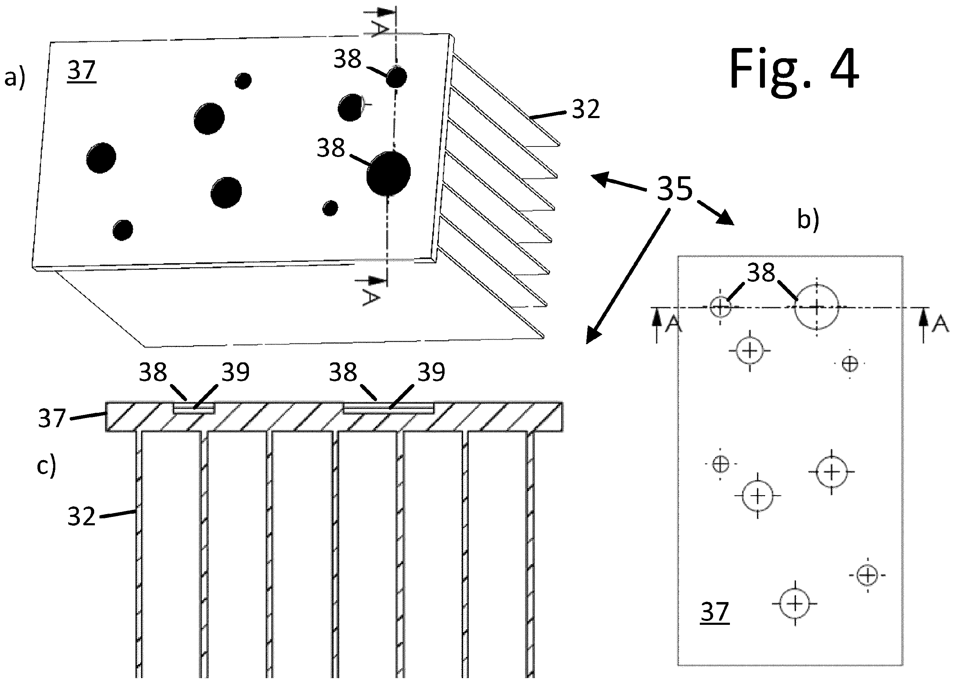

**Fig. 4** zeigt einen Kühlkörper 35, der in einem Wechselrichter 1, 2, 3 verwendbar ist. Der Kühlkörper 35 ist in den Teilfiguren a), b), und c) in verschiedenen Ansichten dargestellt, wobei a) eine perspektivische Ansicht, b) eine Aufsicht auf die Kühlfläche 37 und c) einen Schnitt entlang der Linie A-A in a) und b) darstellt. Der Kühlkörper 35 weist eine Kühlfläche 37 und Kühlrippen 32 auf. In der Kühlfläche 37 sind mehrere Vertiefungen 38 eingebracht, beispielsweise gefräst. Zusätzlich kann ein Graben 36 gemäß Fig. 3 vorgesehen sein, der in Fig. 4 der Übersichtlichkeit halber nicht dargestellt ist.

Auf den Kühlkörper 35 kann insbesondere eine erste Leiterplatte 10 montiert werden, auf der gemäß Fig. 3 THT-Komponenten angeordnet sind, beispielsweise die Zwischenkreiskondensatoren 61 oder ggf. auch die Leistungshalbleiter 12 und/oder die Drosseln 13 in **THT-**Bauweise. Die Vertiefungen 38 sind derart auf der Kühlfläche 37 angeordnet, dass sie mit den Positionen der Anschlussdrähte 62 der THT-Komponenten zusammenfallen. Zusätzlich kann in den jeweiligen Boden der Vertiefungen 38 eine Isolationsschicht 39 eingebracht werden. Dadurch wird eine hinreichende elektrische Isolation zwischen dem Kühlkörper 35 und den Potentialen auf der ersten Leiterplatte 10 gewährleistet.

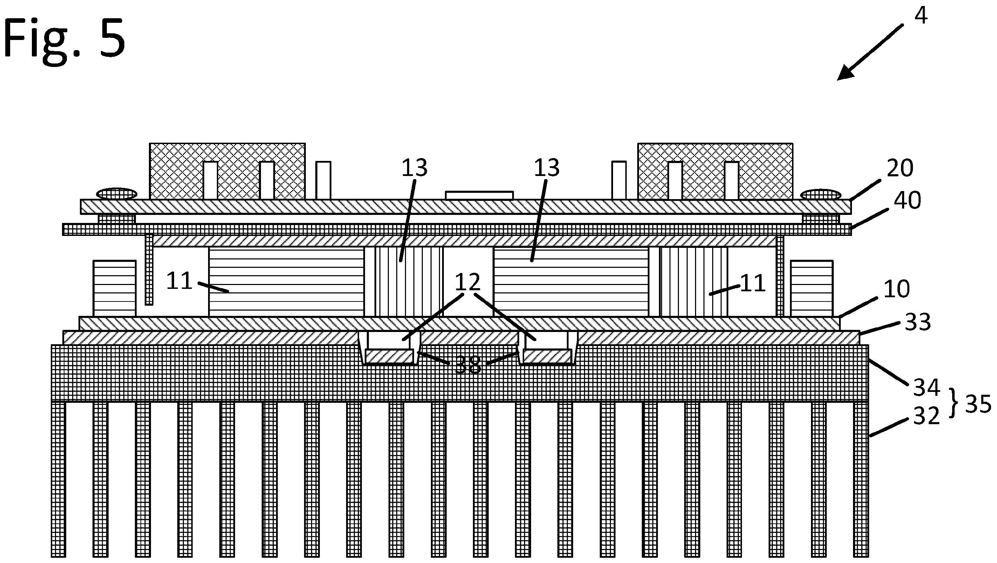

Fig. 5 zeigt eine einen weiteren Wechselrichter 4 in einer vereinfachten Querschnittsdarstellung. Grundsätzlich gleiche Teile, die bereits in Zusammenhang mit Fig. 1 bis 3 beschrieben wurden, sind mit den gleichen Bezugszeichen versehen. Der Wechselrichter 4 umfasst die erste Leiterplatte 10 und die zweite Leiterplatte 20. Die erste Leiterplatte 10 ist auf dem Kühlkörper 35 montiert. Zwischenkreiskondensatoren 11 und Drosseln 13 sind als auf der ersten Leiterplatte 10 angeordnet und als SMD-Bauteile ausgeführt.

Der Kühlkörper 35 des Wechselrichters 3 weist eine Kühlfläche 34 auf, die im wesentlichen ebene Flächenabschnitte umfasst, wobei sich ein Großteil der Kühlfläche 34 in einer ersten Ebene befindet. Zwei Flächenabschnitte der Kühlfläche 34 liegt jedoch in einer zweiten Ebene, so dass der Kühlkörper 35 zwei Vertiefungen 38 aufweist. Der Kühlkörper 34 umfasst Kühlrippen 32, über die Verlustwärme des Wechselrichters 3 an die Umgebung abgegeben wird.

Auf der ersten Leiterplatte 10 sind Leistungshalbleiter 12 angeordnet. Die Leistungshalbleiter 12 sind auf der dem Kühlkörper 35 zugewandten Seite der ersten Leiterplatte 10 montiert. Dabei befinden sich die Leistungshalbleiter 12 an den Positionen der Vertiefungen 38. Dadurch kann die erste Leiterplatte 10 weitgehend flächig und thermisch über das Wärmeleitmaterial 33 gut angebunden auf der Kühlfläche 34 des Kühlkörpers 35 aufliegen, während die Leistungshalbleiter 12 unmittelbar an der "absenkten" Kühlfläche 34 in den Vertiefungen 38 angeordnet sind und somit thermisch optimal an den Kühlkörper 35 angebunden sind. Es versteht sich, dass dazu ein Wärmeleitmaterial zwischen Leitungshalbleiter 12 und Kühlkörper 35 angeordnet sein kann.

### BEZUGSZEICHENLISTE

- 1, 2, 3, 4: Wechselrichter

- 10, 20: Leiterplatte

- 11: Zwischenkreiskondensator
- 12: Leistungshalbleiter
- 13: Drossel
- 14: Steuereinheit
- 15: Kapazität

- 21: Filterkondensator
- 22: Filterdrossel
- 23: Kommunikationsprozessor

- 30, 35: Kühlkörper
- 31, 34, 37: Kühlfläche
- 32: Kühlrippen
- 33: Wärmeleitmaterial
- 36, 38: Vertiefung
- 39: Isolationsschicht

- 40: Blech
- 41: Befestigungsmittel
- 42: Halteblech
- 43: Wärmeleitmaterial
- 44: Führungsblech

- 50: Verbindung
- 51: Verbindungselement

- 61: Zwischenkreiskondensator
- 62: Anschlussdrähte

## Patentansprüche

1. Wechselrichter (1-4) mit einer Nennleistung von mindestens 3 kVA, umfassend eine erste Baugruppe, die eine erste Leiterplatte (10) und eine DC/AC-Konverterstufe umfasst, und eine zweite Baugruppe, die eine zweite Leiterplatte (20) und einen EMV-Filter für die DC/AC-Konverterstufe umfasst, wobei die erste Leiterplatte (10) auf einem Kühlkörper (30,35) montiert ist und im Wesentlichen flächig auf dem Kühlkörper (30,35) aufliegt, wobei die DC/AC-Konverterstufe Wandlerkomponenten aufweist, die Leistungshalbleiter (12), Drosseln (13) und Zwischenkreiskondensatoren (11) umfassen, wobei die Drosseln (13) und die Zwischenkreiskondensatoren (11) gemeinsam auf einer Seite der ersten Leiterplatte (10) und der Kühlkörper (30,35) auf der gegenüberliegenden Seite der ersten Leiterplatte (10) angeordnet sind, wobei die Drosseln (13) und/oder die Leistungshalbleiter (12) über die erste Leiterplatte (10) und ein zwischen der ersten Leiterplatte (10) und dem Kühlkörper (30,35) angeordnetes Wärmeleitmaterial (33) thermisch mit dem Kühlkörper (30,35) verbunden sind, wobei die zweite Leiterplatte (20) auf der dem Kühlkörper (30,35) gegenüberliegenden Seite der ersten Leiterplatte (10) angeordnet ist, wobei ein Blech (40) zwischen der ersten und der zweiten Baugruppe angeordnet und die zweite Leiterplatte (20) auf dem Blech (40) montiert ist, **dadurch gekennzeichnet, dass**
die erste Baugruppe mindestens zwei Drosseln (13) aufweist, wobei mindestens zwei der Drosseln (13) und das Blech (40) über ein zwischen den Drosseln (13) und dem Blech (40) angeordnetes Wärmeleitmaterial (43) thermisch miteinander verbunden sind, und/oder
dass mindestens einer der Zwischenkreiskondensatoren (11) der ersten Baugruppe und das Blech (40) über ein zwischen dem Blech (40) und dem Zwischenkreiskondensator (11) angeordnetes Wärmeleitmaterial (43) thermisch mit dem Blech (40) verbunden sind.

2. Wechselrichter (1-4) nach Anspruch 1, wobei die Wandlerkomponenten weiterhin Filterkondensatoren (21) und/oder Stromsensoren umfassen, die auf der ersten Leiterplatte (10) angeordnet sind.

3. Wechselrichter (1,2,4) nach Anspruch 1 oder 2, wobei sämtliche Wandlerkomponenten als SMD-Komponenten ausgeführt oder in der ersten Leiterplatte (10) integriert sind.

4. Wechselrichter (3) nach Anspruch 1 oder 2, wobei die Leistungshalbleiter (12) sowie die Drosseln (13) als SMD-Komponenten ausgeführt sind, wobei die Zwischenkreiskondensatoren (11) als THT-Komponenten ausgeführt sind, wobei sich Anschlussdrähte (62) der THT-Komponenten, die auf der ersten Leiterplatte (10) angeordnet sind, in einen Raum zwischen der ersten Leiterplatte (10) und dem Kühlkörper (35) erstrecken, wobei die der ersten Leiterplatte (10) zugewandte und im wesentlichen ebene Kühlfläche (34) des Kühlkörpers (35) an den Positionen der Anschlussdrähte (62) Aussparungen aufweist, so dass ein hinreichend großer Abstand zwischen den montierbaren Anschlussdrähten (62) und dem Kühlkörper (35) gewährleistet ist.

5. Wechselrichter (3) nach Anspruch 4, wobei der Kühlkörper (35) ein Strangpressprofil umfasst und eine Vielzahl an Kühlrippen (32) aufweist, wobei die Aussparungen eine grabenförmige Vertiefung (36) in der im Wesentlichen ebenen Kühlfläche (34) des Strangpressprofils umfassen, so dass die Anschlussdrähte (62) in die grabenförmige Vertiefung (36) hineinragen, wobei die grabenförmige Vertiefung (36) bevorzugt parallel zu den Kühlrippen (32) orientiert ist.

6. Wechselrichter (3) nach Anspruch 4, wobei die Aussparungen mehrere Vertiefungen (38) in der Kühlfläche (34,37) des Kühlkörpers (35) umfassen, wobei ein Durchmesser der Vertiefungen (38) so ausgelegt ist, dass genau ein Anschlussdraht (62) eines THT-Bauteils oder die Anschlussdrähte (62) genau eines THT-Bauteils in einer der Vertiefungen (38) angeordnet ist, wobei ein vorgegebener Isolationsabstand zwischen Anschlussdraht (62) und Kühlkörper (35) eingehalten wird.

7. Wechselrichter (1-4) nach einem der vorangehenden Ansprüche, wobei der Abstand zwischen den Leiterplatten (10,20) weniger als fünf Zentimeter und bevorzugt weniger als drei Zentimeter beträgt und/oder wobei der Abstand zwischen der ersten Leiterplatte (10) und der Kühlfläche (31,34,37) des Kühlkörpers (30,35) weniger als ein Zentimeter und bevorzugt weniger als 5 Millimeter beträgt.

8. Wechselrichter (4) nach einem der vorangehenden Ansprüche, wobei die Leistungshalbleiter (12) auf der dem Kühlkörper (35) zugewandten Seite der ersten Leiterplatte (10) angeordnet sind und in direktem thermischen Kontakt zum Kühlkörper (35) stehen, wobei die Kühlfläche (34) des Kühlkörpers (35) optional an den Positionen der Leistungshalbleiter (12) Aussparungen aufweist, so dass die erste Leiterplatte (10) und die Leistungshalbleiter (12) im Wesentlichen denselben Abstand zur Kühlfläche (34) aufweisen.

9. Wechselrichter (1-4) nach einem der vorangehenden Ansprüche, wobei die zweite Baugruppe Filterkomponenten aufweist, die auf einer der ersten Leiterplatte (10) gegenüberliegenden Seite der zweiten Leiterplatte (20) angeordnet sind.

10. Wechselrichter (1-4) nach einem der vorangehenden Ansprüche, wobei der Wechselrichter (1-4) einen Lüfter aufweist, der eine Luftströmung entlang des Blechs (40) zwischen der ersten und der zweiten Baugruppe erzeugt.

11. Wechselrichter (1-4) nach einem der vorangehenden Ansprüche, wobei das Blech (40) Abschnitte (42,44) aufweist, die sich aus der Ebene des Blechs (40) heraus und in den Bauraum der ersten Baugruppe hinein erstrecken.

12. Wechselrichter (1-4) nach einem der vorangehenden Ansprüche, wobei die erste Baugruppe eine DC/DC-Konverterstufe umfasst, wobei die DC/DC-Konverterstufe über die Zwischenkreiskondensatoren (11) mit der DC/AC-Konverterstufe verbunden ist, wobei die Leistungshalbleiter (12) der DC/DC-Konverterstufe bevorzugt als Siliziumkarbid- oder Galliumnitrid-Halbleiter und die Leistungshalbleiter (12) der DC/AC-Konverterstufe bevorzugt als Siliziumkarbid- oder Galliumnitrid-Halbleiter ausgeführt sind.

13. Wechselrichter (1-4) nach einem der vorangehenden Ansprüche, wobei die erste Baugruppe eine Steuereinheit (14) umfasst, die auf der ersten Leiterplatte (10) angeordnet und dazu eingerichtet ist, die Leistungshalbleiter (12) mittels eines pulsweitenmodulierten Taktsignals anzusteuern sowie Strom- und Spannungsmesswerte der DC/AC-Konverterstufe zu erfassen, wobei die Steuereinheit (14) bevorzugt dazu eingerichtet ist, die Leistungshalbleiter (12) mit einer Schaltfrequenz von mindestens 100 kHz zu schalten.

14. Wechselrichter (1-4) nach einem der vorangehenden Ansprüche, wobei der Wechselrichter (1-4) dazu eingerichtet ist, eine elektrische Leistung mindestens einer anschließbaren Gleichspannungseinheit über die DC/AC-Konverterstufe und den EMV-Filter mit einer Phasenleitung eines Niederspannungsnetzes auszutauschen und insbesondere normkonform in das Niederspannungsnetz einzuspeisen und/oder aus dem Niederspannungsnetz zu entnehmen.

15. Wechselrichter (1-4) nach einem der vorangehenden Ansprüche, wobei der Wechselrichter (1-4) dreiphasig ausgeführt und dazu eingerichtet ist, elektrische Leistung auf allen drei Phasen mit einem dreiphasigen Niederspannungsnetz auszutauschen.

## Claims

1. An inverter (1-4) with a rated power of at least 3 kVA, comprising a first assembly which comprises a first printed circuit board (10) and a DC/AC converter stage, and a second assembly which comprises a second printed circuit board (20) and an EMC filter for the DC/AC converter stage, wherein the first printed circuit board (10) is mounted on a heat sink (30, 35) and lies substantially flat on the heat sink (30, 35), wherein the DC/AC converter stage has converter components which comprise power semiconductors (12), chokes (13) and link circuit capacitors (11), wherein the chokes (13) and the link circuit capacitors (11) are arranged together on one side of the first printed circuit board (10) and the heat sink (30, 35) are arranged on the opposite side of the first printed circuit board (10), wherein the chokes (13) and/or the power semiconductors (12) are thermally connected to the heat sink (30, 35) via the first printed circuit board (10) and a thermally conductive material (33) arranged between the first printed circuit board (10) and the heat sink (30, 35), wherein the second printed circuit board (20) is arranged on the side of the first printed circuit board (10) opposite the heat sink (30, 35), wherein a metal sheet (40) is arranged between the first and the second assembly and the second printed circuit board (20) is mounted on the metal sheet (40), **characterised in that**
the first assembly has at least two chokes (13), wherein at least two of the chokes (13) and the metal sheet (40) are thermally connected to one another via a heat-conducting material (43) arranged between the chokes (13) and the metal sheet (40), and/or
at least one of the link circuit capacitors (11) of the first assembly and the metal sheet (40) are thermally connected to the metal sheet (40) via a heat-conducting material (43) arranged between the metal sheet (40) and the link circuit capacitor (11).

2. The inverter (1-4) as claimed in claim 1, wherein the converter components further comprise filter capacitors (21) and/or current sensors arranged on the first printed circuit board (10).

3. The inverter (1, 2, 4) as claimed in claim 1 or 2, wherein all converter components are designed as SMD components or are integrated in the first printed circuit board (10).

4. The inverter (3) as claimed in claim 1 or 2, wherein the power semiconductors (12) and the chokes (13) are designed as SMD components, wherein the link circuit capacitors (11) are designed as THT components, wherein connection wires (62) of the THT components, which are arranged on the first printed circuit board (10), extend into a space between the first printed circuit board (10) and the heat sink (35), wherein the cooling surface (34) of the heat sink (35) facing the first printed circuit board (10) and being essentially flat has recesses at the positions of the connecting wires (62) so that a sufficiently large distance between the mountable connecting wires (62) and the heat sink (35) is ensured.

5. The inverter (3) as claimed in claim 4, wherein the heat sink (35) comprises an extruded profile and has a plurality of cooling fins (32), wherein the recesses comprise a trench-shaped depression (36) in the substantially flat cooling surface (34) of the extruded profile, so that the connecting wires (62) protrude into the trench-shaped depression (36), wherein the trench-shaped depression (36) is preferably oriented parallel to the cooling fins (32).

6. The inverter (3) according to claim 4, wherein the recesses comprise a plurality of depressions (38) in the cooling surface (34, 37) of the heat sink (35), wherein a diameter of the depressions (38) is designed such that exactly one connection wire (62) of a THT component or the connection wires (62) of exactly one THT component are arranged in one of the depressions (38), whereby a predetermined insulation distance between the connection wire (62) and the heat sink (35) is maintained.

7. Inverter (1-4) according to one of the preceding claims, wherein the distance between the printed circuit boards (10, 20) is less than five centimetres and preferably less than three centimetres and/or wherein the distance between the first printed circuit board (10) and the cooling surface (31, 34, 37) of the heat sink (30, 35) is less than one centimetre and preferably less than 5 millimetres.

8. Inverter (4) according to one of the preceding claims, wherein the power semiconductors (12) are arranged on the side of the first printed circuit board (10) facing the heat sink (35) and are in direct thermal contact with the heat sink (35), wherein the cooling surface (34) of the heat sink (35) optionally has recesses at the positions of the power semiconductors (12) so that the first printed circuit board (10) and the power semiconductors (12) are essentially at the same distance from the cooling surface (34).

9. The inverter (1-4) as claimed in one of the preceding claims, wherein the second assembly comprises filter components arranged on a side of the second printed circuit board (20) opposite the first printed circuit board (10).

10. The inverter (1-4) according to one of the preceding claims, wherein the inverter (1-4) comprises a fan that generates an air flow along the metal sheet (40) between the first and second assemblies.

11. The inverter (1-4) according to one of the preceding claims, wherein the metal sheet (40) has sections (42, 44) which extend out of the plane of the metal sheet (40) and into the installation space of the first assembly.

12. The inverter (1-4) according to one of the preceding claims, wherein the first assembly comprises a DC/DC converter stage, wherein the DC/DC converter stage is connected to the DC/AC converter stage via the link circuit capacitors (11), wherein the power semiconductors (12) of the DC/DC converter stage are preferably silicon carbide or gallium nitride semiconductors and the power semiconductors (12) of the DC/AC converter stage are preferably silicon carbide or gallium nitride semiconductors.

13. The inverter (1-4) according to one of the preceding claims, wherein the first assembly comprises a control unit (14) which is arranged on the first printed circuit board (10) and is designed to control the power semiconductors (12) by means of a pulse width modulated clock signal and to detect current and voltage measurements of the DC/AC converter stage, wherein the control unit (14) is preferably designed to switch the power semiconductors (12) at a switching frequency of at least 100 kHz.

14. The inverter (1-4) according to one of the preceding claims, wherein the inverter (1-4) is designed to exchanging electrical power from at least one connectable DC voltage unit via the DC/AC converter stage and the EMC filter with a phase line of a low-voltage network and, in particular, feeding it into the low-voltage network and/or withdrawing it from the low-voltage network in accordance with standards.

15. The inverter (1-4) according to one of the preceding claims, wherein the inverter (1-4) is designed to be three-phase and is set up to exchange electrical power on all three phases with a three-phase low-voltage network.

## Revendications

1. Onduleur (1-4) d'une puissance nominale d'au moins 3 kVA, comprenant un premier module qui comprend une première carte de circuit imprimé (10) et un étage convertisseur CC/CA, et un deuxième module qui comprend une deuxième carte de circuit imprimé (20) et un filtre CEM pour l'étage convertisseur CC/CA, la première carte de circuit imprimé (10) étant montée sur un dissipateur thermique (30, 35) et reposant essentiellement à plat sur le dissipateur thermique (30, 35), l'étage convertisseur CC/CA comportant des composants de conversion qui comprennent des semi-conducteurs de puissance (12), des selfes (13) et des condensateurs de circuit intermédiaire (11), les selfs (13) et les condensateurs de circuit intermédiaire (11) étant disposés ensemble sur un côté de la première carte de circuit imprimé (10) et le dissipateur thermique (30, 35) sur le côté opposé de la première carte de circuit imprimé (10), les selfs (13) et/ou les semi-conducteurs de puissance (12) étant reliés thermiquement au dissipateur thermique (30, 35) par l'intermédiaire de la première carte de circuit imprimé (10) et d'un matériau thermoconducteur (33) disposé entre la première carte de circuit imprimé (10) et le dissipateur thermique (30, 35), la deuxième carte de circuit imprimé (20) étant disposée sur le côté de la première carte de circuit imprimé (10) opposé au dissipateur thermique (30, 35), une tôle (40) étant disposée entre le premier et le deuxième module et la deuxième carte de circuit imprimé (20) étant montée sur la tôle (40), **caractérisé en ce que**
le premier module comporte au moins deux selfs (13), au moins deux des selfs (13) et la tôle (40) étant reliées thermiquement entre elles par l'intermédiaire d'un matériau thermoconducteur (43) disposé entre les selfs (13) et la tôle (40), et/ou
au moins l'un des condensateurs de circuit intermédiaire (11) du premier module et la tôle (40) sont reliés thermiquement à la tôle (40) par l'intermédiaire d'un matériau thermoconducteur (43) disposé entre la tôle (40) et le condensateur de circuit intermédiaire (11).

2. Onduleur (1-4) selon la revendication 1, les composants du convertisseur comprenant en outre des condensateurs de filtrage (21) et/ou des capteurs de courant qui sont disposés sur la première carte de circuit imprimé (10).

3. Onduleur (1, 2, 4) selon la revendication 1 ou 2, tous les composants du convertisseur étant réalisés sous forme de composants SMD ou intégrés dans la première carte de circuit imprimé (10).

4. Onduleur (3) selon la revendication 1 ou 2, les semi-conducteurs de puissance (12) et les selfs (13) étant réalisés sous forme de composants SMD, les condensateurs de circuit intermédiaire (11) étant réalisés sous forme de composants THT, les fils de raccordement (62) des composants THT, qui sont disposés sur la première carte de circuit imprimé (10), s'étendent dans un espace entre la première carte de circuit imprimé (10) et le dissipateur thermique (35), la surface de refroidissement (34) du dissipateur thermique (35), tournée vers la première carte de circuit imprimé (10) et essentiellement plane, présentant des évidements aux emplacements des fils de raccordement (62), de manière à garantir une distance suffisamment grande entre les fils de raccordement (62) pouvant être montés et le dissipateur thermique (35).

5. Onduleur (3) selon la revendication 4, le dissipateur thermique (35) comprenant un profilé extrudé et présentant une pluralité d'ailettes de refroidissement (32), les évidements comprenant un renfoncement en forme de rainure (36) dans la surface de refroidissement (34) essentiellement plane du profilé extrudé, de sorte que les fils de raccordement (62) font saillie dans le renfoncement en forme de rainure (36), le renfoncement en forme de rainure (36) étant de préférence orienté parallèlement aux ailettes de refroidissement (32).

6. Onduleur (3) selon la revendication 4, les évidements comprenant plusieurs renfoncements (38) dans la surface de refroidissement (34, 37) du dissipateur thermique (35), le diamètre des renfoncements (38) étant conçu de telle sorte qu'un seul fil de connexion (62) d'un composant THT ou les fils de connexion (62) d'un seul composant THT soient disposés dans l'un des renfoncements (38), une distance d'isolation prédéfinie étant respectée entre le fil de connexion (62) et le dissipateur thermique (35).

7. Onduleur (1-4) selon l'une des revendications précédentes, la distance entre les cartes de circuits imprimés (10, 20) étant inférieure à cinq centimètres et de préférence inférieure à trois centimètres et/ou la distance entre la première carte de circuits imprimés (10) et la surface de refroidissement (31, 34, 37) du dissipateur thermique (30, 35) étant inférieure à un centimètre et de préférence inférieure à 5 millimètres.

8. Onduleur (4) selon l'une des revendications précédentes, les semi-conducteurs de puissance (12) étant disposés sur le côté de la première carte de circuit imprimé (10) tourné vers le dissipateur thermique (35) et étant en contact thermique direct avec le dissipateur thermique (35), la surface de refroidissement (34) du dissipateur thermique (35) présentant éventuellement des évidements aux emplacements des semi-conducteurs de puissance (12), de sorte que la première carte de circuit imprimé (10) et les semi-conducteurs de puissance (12) présentent sensiblement le même écart par rapport à la surface de refroidissement (34).

9. Onduleur (1-4) selon l'une des revendications précédentes, le deuxième module comportant des composants de filtrage qui sont disposés sur un côté de la deuxième carte de circuit imprimé (20) opposé à la première carte de circuit imprimé (10).

10. Onduleur (1-4) selon l'une des revendications précédentes, l'onduleur (1-4) comportant un ventilateur qui génère un flux d'air le long de la tôle (40) entre le premier et le deuxième module.

11. Onduleur (1-4) selon l'une des revendications précédentes, la tôle (40) comportant des parties (42, 44) qui s'étendent hors du plan de la tôle (40) et dans l'espace de montage du premier module.

12. Onduleur (1-4) selon l'une des revendications précédentes, le premier module comprenant un étage convertisseur CC/CC, l'étage convertisseur CC/CC étant relié à l'étage convertisseur CC/CA par l'intermédiaire des condensateurs de circuit intermédiaire (11), les semi-conducteurs de puissance (12) de l'étage convertisseur CC/CC étant de préférence réalisés sous forme de semi-conducteurs en carbure de silicium ou en nitrure de gallium et les semi-conducteurs de puissance (12) de l'étage convertisseur CC/CA étant de préférence réalisés sous forme de semi-conducteurs en carbure de silicium ou en nitrure de gallium.

13. Onduleur (1-4) selon l'une des revendications précédentes, le premier module comprenant une unité de commande (14) qui est disposée sur la première carte de circuit imprimé (10) et qui est conçue pour commander les semi-conducteurs de puissance (12) au moyen d'un signal d'horloge modulé en largeur d'impulsion et pour enregistrer les valeurs mesurées du courant et de la tension de l'étage convertisseur CC/CA, l'unité de commande (14) étant de préférence conçue pour commuter les semi-conducteurs de puissance (12) à une fréquence de commutation d'au moins 100 kHz.

14. Onduleur (1-4) selon l'une des revendications précédentes, l'onduleur (1-4) étant conçu pour échanger une puissance électrique d'au moins une unité à tension continue raccordable via l'étage convertisseur CC/CA et le filtre CEM avec une ligne de phase d'un réseau basse tension et, en particulier, pour l'injecter dans le réseau basse tension et/ou la prélever du réseau basse tension conformément aux normes.

15. Onduleur (1-4) selon l'une des revendications précédentes, l'onduleur (1-4) étant réalisé en version triphasée et étant conçu pour échanger de la puissance électrique sur les trois phases avec un réseau triphasé à basse tension.
